# EUROPÄISCHE PATENTSCHRIFT

(11) **EP 2 775 483 B1**
(45) Veröffentlichungstag und Bekanntmachung des Hinweises auf die Patenterteilung: **23.11.2016**
(21) Anmeldenummer: 14158111.6
(22) Anmeldetag: 06.03.2014
(51) Int. Cl.: H01B 1/22, H01L 41/047, C08L 83/04

(54) **Elektrisch leitendes Material und dessen Verwendung als Elektrode in einem dielektrischen Elastomerkomposit oder als elektrisch leitende, dehnbare Faser**
Electrically conductive material and its use as an electrode in a dielectric elastomer composite or electrically conductive, elastic fibre
Matériau conducteur d'électricité et son utilisation comme électrode dans un composite d'élastomère diélectrique ou en tant que fibre extensible conductrice d'électricité

(30) Priorität: 06.03.2013 DE 102013102246
(43) Veröffentlichungstag der Anmeldung: 10.09.2014
(73) Patentinhaber: Fraunhofer-Gesellschaft zur Förderung der angewandten Forschung e.V., 80686 München (DE)
(72) Erfinder: Böse, Holger, 97080 Würzburg (DE); Uhl, Detlev, 97318 Kitzingen (DE); Rabindranath, Raman, 51147 Köln (DE); Herborn, Ralf, 97204 Höchberg (DE)
(74) Vertreter: Strehl Schübel-Hopf & Partner

(56) Entgegenhaltungen:
- US-A1- 2004 058 240
- US-A1- 2007 200 467
- YOUNGSEOK OH ET AL: "Silver-plated carbon nanotubes for silver/conducting polymer composites", NANOTECHNOLOGY, IOP, BRISTOL, GB, Bd. 19, Nr. 49, 10. Dezember 2008 (2008-12-10), Seite 495602, XP020144940, ISSN: 0957-4484, DOI: 10.1088/0957-4484/19/49/495602
- HAN-SHENG CHUANG ET AL: "Design, fabrication and characterization of a conducting PDMS for microheaters and temperature sensors", JOURNAL OF MICROMECHANICS & MICROENGINEERING, INSTITUTE OF PHYSICS PUBLISHING, BRISTOL, GB, Bd. 19, Nr. 4, 1. April 2009 (2009-04-01), Seite 45010, XP020153377, ISSN: 0960-1317, DOI: 10.1088/0960-1317/19/4/045010
- MARK KUJAWSKI ET AL: "PDMS/graphite stretchable electrodes for dielectric elastomer actuators", PROCEEDINGS OF SPIE, Bd. 7642, 25. März 2010 (2010-03-25), Seiten 76420R-76420R-9, XP055115263, ISSN: 0277-786X, DOI: 10.1117/12.847249

## Beschreibung

Die vorliegende Erfindung betrifft ein elektrisch leitfähiges Material, das neben leitfähigen, zumindest teilweise aus Metall bestehenden Partikeln nichtmetallische leitfähige Partikel sowie einen Binder enthält. Dieses Material eignet sich für Anwendungen, in denen es einer starken Dehnung unterworfen werden soll, kann oder muss, wie beispielsweise als Elektrode in einem Dielektrischen Elastomerkomposit oder als elektrisch leitende, dehnbare Faser.

Dielektrische Elastomere sind Elastomerkomposite aus oder mit einer elektrisch isolierenden, stark dehnbaren Elastomerfolie, die beidseitig mit jeweils einer ebenfalls stark dehnbaren Elektrodenschicht beschichtet ist. Derartige Elastomerkomposite können als Aktoren zur Erzeugung von Bewegungen, als Sensoren zur Dehnungs- oder Druckmessung und auch als Generatoren zur Wandlung von mechanischer in elektrische Energie eingesetzt werden.

Die Elektrodenschichten von dielektrischen Elastomeren sollten eine sehr hohe elektrische Leitfähigkeit aufweisen. Dies ist besonders bei dielektrischen Elastomeraktoren, die hochdynamisch bei hohen Frequenzen arbeiten, von entscheidender Bedeutung. Eine weitere Forderung besteht darin, dass die Leitfähigkeit auch bei hohen Dehnungen noch ausreichend groß ist. Dies ist z. B. bei stark dehnenden dielektrischen Elastomersensoren wichtig. Auch bei dielektrischen Elastomergeneratoren muss bei starken Dehnungen noch eine sehr hohe Leitfähigkeit vorhanden sein, um die entsprechenden Energieverluste zu begrenzen. Außerdem soll der mechanische Widerstand der Elektrodenschichten möglichst gering sein, da der dielektrische Elastomeraktor bei seiner Bewegung das Elektrodenmaterial mitdehnen muss, wodurch seine Leistungsfähigkeit eingeschränkt wird.

Leitfähige Silicon- bzw. Polydimethylsiloxan-(PDMS-)Materialien für den Einsatz in planaren und 3D Mikrostrukturen mit Hilfe von "soft lithography", z.B. für die Herstellung von Mikrofluidik tragenden Chips, sind bei X. Niu et al., Adv. Mater. 19, 2682-2686 (2007) beschrieben. Sie bestehen aus einem mit Ruß oder Silberplättchen gefüllten PDMS. H.-S. Chuang und S. Wereley, J. Micromech. Microeng. 19, 045010 (2009) schlagen vor, mit Silber beschichtete Plättchen als leitfähiges Füllmaterial von PDMS einzusetzen, um Mikroheizvorrichtungen und Temperatursensoren herzustellen.

Bisherige dielektrische Elastomere tragen als Elektroden meist Schichten aus kohlenstoffhaltigen Partikeln wie Graphit oder Ruß oder auch Carbon Nanotubes, die entweder frei auf der Elastomeroberfläche aufliegen oder durch eine Flüssigkeit oder ein Elastomer gebunden sind. So schlagen beispielsweise M. Kujawski, J. Pearse und E. Smela,

Proc. of SPIE Vol. 7642 (2010) vor, Graphit als nichtmetallisch leitfähiges Füllmaterial von PDMS einzusetzen, um dielektrische Elastomer-Aktoren herzustellen. Mit solchen Elektrodenschichten lassen sich jedoch keine sehr hohen Leitfähigkeiten erreichen. Ein weiteres bekanntes Elektrodenmaterial auf dielektrischen Elastomeraktoren besteht aus dünnen Silberschichten. Dabei weist die Elastomeroberfläche eine gewellte Struktur auf, die von der Silberschicht bedeckt wird, siehe z.B. US 7,573,064 B2. Bei einer Dehnung der Elastomerfolie ebnen sich die Wellen ein, ohne dass die Silberschicht zerreißt. Auf diese Weise wird zwar eine sehr hohe Leitfähigkeit der Elektrodenschichten erreicht, die auch unter begrenzter Dehnung noch bestehen bleibt. Wird allerdings die Dehnung der Elastomerfolie über das Maß gesteigert, bei dem das Wellenprofil bereits eingeebnet ist, so zerreißt die Silberschicht. Dies ist auch bereits bei einer geringen Dehnung in der dazu senkrechten Richtung der Fall. Außerdem erzeugt die zwar dünne, aber aus massivem Metall bestehende Silberschicht einen relativ hohen mechanischen Widerstand bei der Dehnung.

Mit den Kenntnissen des Standes der Technik lassen sich keine dielektrischen Elastomere mit Elektrodenschichten herstellen, die eine sehr hohe Leitfähigkeit, auch unter hoher Dehnung, aufweisen und keinen starken mechanischen Widerstand erzeugen.

Die für Elektrodenschichten von Dielektrischen Elastomeren geforderten Eigenschaften werden auch für andere Gegenstände oder Vorrichtungen benötigt, die als solche oder in denen bestimmte leitfähige Komponenten einer hohen Dehnung unterworfen werden sollen, können oder müssen, wie beispielsweise leitfähige Elastomerfasern. Derartige Elastomerfasern sollen auch unter Dehnung ihre Leitfähigkeitseigenschaften möglichst weitgehend beibehalten.

Die Aufgabe der vorliegenden Erfindung liegt daher in der Bereitstellung eines Materials, das sich zum Einsatz als leitfähiges, stark dehnbares Material oder als solche Komponente in entsprechenden Gegenständen oder Vorrichtungen eignet, z.B. als Elektrodenschicht dielektrischer Elastomerkomposite oder in Form von leitfähigen Elastomerfasern. Das Material soll sowohl in Schichtform als auch in Faserform eine sehr hohe Leitfähigkeit aufweisen, welche auch unter hohen Dehnungen noch weitgehend beibehalten wird. Bevorzugt soll der mechanische Widerstand des Materials in Schichtform unter Dehnung relativ gering sein, um Aktuationsdehnungen zu erleichtern.

In Lösung dieser Aufgabe stellt die Erfindung ein elektrisch leitendes Material bereit, umfassend mindestens die folgenden Bestandteile:
(a) leitfähige Partikel, die zumindest teilweise aus Metall bestehen und eine anisotrope Gestalt besitzen,
(b) nichtmetallische leitfähige Partikel, ausgewählt unter Partikeln aus Kohlenstoff-Materialien sowie Partikeln aus leitfähigen organischen Polymeren und
(c) ein elastomeres Bindemittel, ausgewählt unter Silicon, Fluorsilicon, Polyurethan (PUR), Polynorbornen, Naturkautschuk (NR), Styrol-Butadien (SBR), Isobutylen-Isopren (IIR), Ethylen-Propylen-Dien-Terpolymer (EPDM/EPM), Poly-Chlorbutadien (CR), Chlorsulfoniertem Polyethylen (CSM), Acrylnitril-Butadien (NBR), Hydriertem Acrylnitril-Butadien (HNBR), einem thermoplastischen Elastomer, einem teilvernetzten Blend auf Polyolefin-Basis, oder einem thermoplastischen Urethan-Copolymer, ausgewählt aus Copolymeren mit aromatischem Hartsegment und Ester-Weichsegment (TPU-ARES), aromatischem Hartsegment und Ether-Weichsegment (TPU-ARET) und aromatischem Hartsegment und Ester/Ether-Weichsegment (TPU-AREE) und Mischungen der vorgenannten Elastomer-Materialien,
wobei der Anteil der metallischen anisotropen Partikel mindestens 50 Gew.-% und/oder mindestens 10 Vol.-% beträgt.

Das erfindungsgemäße Material enthält leitfähige Partikel aus Metall oder einer metallischen Beschichtung, welche eine anisotrope (unregelmäßige) Form besitzen. Durch die anisotrope Form der leitfähigen Partikel lassen sich bereits mit relativ geringen Volumengehalten hohe Leitfähigkeiten erzielen. Durch die Kombination mit den nichtmetallischen leitfähigen Partikeln geht der elektrische Kontakt zwischen den anisotropen metallischen Partikeln bei einer Dehnung des Materials, sei es in dessen Form als Schicht oder als Faser, nicht so leicht verloren.

Die Form der Partikel ist dem Grunde nach beliebig, sofern diese unregelmäßig zumindest in dem Sinne ist, dass die Partikel in einer oder in zwei der drei Raumrichtungen eine größere Ausdehnung besitzen als in der bzw. den restlichen Raumrichtung(en). Beispiele für die anisotropen leitfähigen Partikel sind Flakes (regelmäßige oder unregelmäßige Plättchen, deren Ausdehnung in der x-y-Ebene größer ist als in z-Richtung), Stäbchen (regelmäßig oder unregelmäßig; bei diesen ist die Länge in z-Richtung größer als die Ausdehnung in der x-y-Ebene) oder Fasern, auch mit verzweigten Strukturen. Flakes oder Plättchen sind bevorzugt. Diese können zusätzlich eine "unregelmäßige" Form in dem Sinne aufweisen, dass sie keine glatte Hüllfläche besitzen, sondern Ausbuchtungen oder Einbuchtungen oder dergleichen.

Die leitfähigen Partikel der Erfindung können aus einem Metall wie Aluminium, Eisen, Kupfer, Nickel, Silber, Gold und/oder Platin bestehen oder eines dieser Metalle enthalten oder aus einer Mischung mehrerer dieser Metalle bestehen oder eine solche Mischung enthalten. Sofern die leitfähigen Partikel Metall enthalten, aber nicht vollständig daraus bestehen, befindet sich das Metall vorzugsweise auf der Oberfläche der Partikel, z.B. in Form einer Beschichtung. In einer bevorzugten Ausführungsform der Erfindung wird Silber als Metall ausgewählt, insbesondere für beschichtete Partikel. Diese Ausführungsform ist mit allen die Form der Partikel betreffenden Ausführungsformen kombinierbar.

Als Kern von beschichteten Partikeln können dem Grunde nach beliebige Materialien verwendet werden. Günstig sind nichtleitende anorganische Materialien wie z.B. Glas oder andere (z.B. billigere) Metalle; es sind aber auch organische Materialien (insbesondere Kunststoffe) einsetzbar. Auch eine Kombination mehrerer Materialien, die leitend und/oder nichtleitend sein können, ist möglich.

In einer spezifischen Ausführungsform werden silberbeschichtete Partikel, insbesondere in der Form von Flakes (Plättchen) mit einem Kern aus Glas, aus Keramik, aus einem Silikat oder aus einem anderen Metall wie z. B. Kupfer eingesetzt.

In einer anderen Ausführungsform bestehen die Partikel aus agglomerierten Nanopartikeln und haben ihre unregelmäßige Form durch die Agglomeration dieser Partikel gewonnen.

Günstig ist es, wenn die anisotropen leitfähigen Partikel in mindestens einer Dimension eine Größe von unter 2 µm, bevorzugt von unter 1 µm, besonders bevorzugt von unter 0,5 µm aufweisen. In den anderen Dimensionen oder zumindest in einer weiteren Dimension können sie größer sein und dabei beispielsweise (z.B. im Falle von Flakes oder Plättchen) einen Durchmesser aufweisen, der mindestens doppelt so groß ist wie ihre Dicke, oder (z.B. im Falle von Stäbchen) eine Länge aufweisen, die mindestens doppelt so groß ist wie ihr Durchmesser. Das Verhältnis der einen zu den beiden anderen Dimensionen oder der zwei zu der dritten Dimension (das Aspektverhältnis) kann noch stärker abweichen und z.B. zwischen 5:1 und 10:1 oder sogar 20:1 und darüber liegen. Bei Fasern kann das Aspektverhältnis natürlich noch größer sein.

Ein wesentlicher Aspekt der Erfindung liegt darin, dass die anisotropen leitfähigen Partikel in dem leitfähigen Material mit nichtmetallischen leitfähigen Partikeln kombiniert werden, bei denen es sich um Kohlenstoffpartikel und/oder um Partikel aus einem leitfähigen organischen Polymeren oder einer Mischung solcher Polymere handeln kann. Die Kohlenstoffpartikel können z. B. aus Ruß, Graphit, Graphen, Kohlenstoff-Nanoröhren (Carbon Nanotubes) bestehen. Die Partikel aus leitfähigen Polymeren können Polyanilin-, Polyacetylen-, Polypyrrol-, Polyparaphenylen- oder Polythiophen-Partikel oder Partikel aus Mischungen dieser Materialien sein. Verschiedene Arten dieser Partikel, darunter auch Kombinationen aus Kohlenstoffpartikeln mit Partikeln aus leitfähigen Polymeren, können beliebig kombiniert werden.

Überraschend wird durch den Einsatz der Kombination aus nichtmetallischen leitfähigen Partikeln mit metallischen, anisotropen Partikeln der Kontakt zwischen den metallischen leitfähigen Partikeln auch bei zunehmender Dehnung fast unverändert beibehalten, derart, dass die spezifische elektrische Leitfähigkeit des erfindungsgemäßen Materials trotz starker Dehnung (Elongation) nicht stark abnimmt. Dabei handelt es sich um einen synergistischen Effekt, der wesentlich größer ist als die Summe der Effekte, die aufgrund von Leitfähigkeitsmessungen des Binders mit den metallischen anisotropen Partikeln einerseits und des Binders mit den nichtmetallischen leitfähigen Partikeln andererseits zu erwarten gewesen wären. Außerdem sind die mechanischen Eigenschaften des erfindungsgemäßen Materials denen eines Materials, in dem die nichtmetallischen elektrisch leitenden Partikel fehlen, überlegen. Insbesondere kohlenstoffhaltige Partikel können diesbezüglich günstige Effekte haben. So wird bei der Verwendung von Ruß, Graphit oder dergleichen im erfindungsgemäßen Material dieses mechanisch weicher, wodurch die Dehnung mit einem geringeren Energieaufwand durchgeführt werden kann. Eine Kombination von Ruß und einem anderen kohlenstoffhaltigen Material wie Graphit erhöht diesen Effekt weiter. Kohlenstoffhaltiges Material wie Ruß wirkt darüber hinaus einer Sedimentation der anisotropen leitfähigen Partikel in relativ niederviskosen Bindern bzw. deren Ausgangsmaterialien und damit einer Entmischung vor der Verfestigung des Binders entgegen.

Der Anteil der metallischen anisotropen Partikel im erfindungsgemäßen Material liegt vorzugsweise bei mindestens ca. 50 Gew.-%, vorzugsweise mindestens ca. 75 Gew.-% und/oder mindestens 10 Vol.-%, vorzugsweise mindestens 20 Vol.-%, ggf. sogar mindestens 30 Vol.-%. Der Anteil der nichtmetallischen leitenden Partikel liegt günstigerweise bei mindestens 1,5 Vol.-% und beträgt vorzugsweise mindestens 2 Vol.-% und stärker bevorzugt mindestens 2,5 Vol.-%. Die Obergrenze für die nichtmetallischen Teilchen ist nicht kritisch; sie wird durch die Materialkosten und einen genügenden Anteil an Binder bestimmt und kann z.B. bei 10 Vol.-%, stärker bevorzugt bei ca. 8 Vol.-% liegen.

In besonders günstigen Ausgestaltungen der Erfindung werden ca. 10 bis 25 Vol.-%, vorzugsweise 15 bis 20 Vol.-% metallische anisotrope Partikel mit ca. 2 bis 8 Vol.-%, vorzugsweise 3 bis 6 Vol.-% der nichtmetallischen Partikel kombiniert, wobei der Rest des Materials vorzugsweise aus dem Binder besteht.

Das Bindemittel selbst wird je nach Verwendungszweck des erfindungsgemäßen Materials gewählt. Während für dessen Einsatz z.B. in Elektrodenschichten von Dielektrischen Elastomeren eine Beschränkung auf spezifische Materialien nicht geboten ist und sich als Bindemittel hierfür z.B. eine Flüssigkeit, ein Öl, eine weiche, z.B. pastöse Masse oder ein weiches, flexibles Material eignet, wobei es sich dabei in der Regel um ein organisches, vorzugsweise vernetzbares Material und/oder gut an der nichtleitenden Elastomerfolie haftendes Material handelt, wird für die Verwendung als elektrisch leitende Faser ein Elastomer benötigt. Bei diesem kann es sich um ein Silicon, Fluorsilicon, Polyurethan (PUR), Polynorbornen, Naturkautschuk (NR), Styrol-Butadien (SBR), Isobutylen-Isopren (IIR), Ethylen-Propylen-Dien-Terpolymer (EPDM/EPM), Poly-Chlorbutadien (CR), Chlorsulfoniertes Polyethylen (CSM), Acrylnitril-Butadien (NBR), Hydriertes Acrylnitril-Butadien (HNBR), ein thermoplastisches Elastomer, vorzugsweise ein thermoplastisches Styrol-Copolymer, ausgewählt unter Styrol-Butadien-Styrol- (SBS-), Styrol-Ethylen-Butadien-Styrol-(SEBS-), Styrol-Ethylen-Propylen-Styrol- (SEPS-), Styrol-Ethylen-Ethylen-Propylen-Styrol-(SEEPS-) oder Styrol-Isopren-Styrol- (SIS-) Copolymeren, ein teilvernetztes Blend auf Polyolefin-Basis, vorzugsweise ausgewählt unter Blends aus Ethylen-Propylen-Dien-Kautschuken und Polypropylen (EPDM/PP), aus Nitril-Butadien-Kautschuk und Polypropylen (NBR/PP) und aus Ethylen-Propylen-Dien-Kautschuk und Polyethylen (EPDM/PE), oder um ein thermoplastisches Urethan-Copolymer handeln, ausgewählt aus Copolymeren mit aromatischem Hartsegment und Ester-Weichsegment (TPU-ARES), aromatischem Hartsegment und Ether-Weichsegment (TPU-ARET) und aromatischem Hartsegment und Ester/Ether-Weichsegment (TPU-AREE). Auch Mischungen der genannten Materialien sind möglich. Bevorzugt handelt es sich um ein Siliconelastomer, ein Polyurethanelastomer oder ein thermoplastisches Elastomer.

In allen Varianten der Erfindung, und dabei insbesondere für den Einsatz als Elektrodenschicht, wird als Bindemittel in einer bevorzugten Ausführungsform ein nicht oder nur schwach und/oder weitmaschig vernetztes Elastomer eingesetzt.

In dieser Ausführungsform, gegebenenfalls aber auch in anderen Ausführungsformen, werden die anisotropen leitfähigen Partikel und die nichtmetallischen leitenden Partikel mit einer noch nicht oder nicht vollständig vernetzen Vorstufe des Elastomeren vermischt, und diese Mischung wird sodann in die gewünschte Form (als Elektrodenschicht auf ggf. bereits fertig auspolymerisierte nichtleitende Elastomerfolien oder in Faserform, beispielsweise durch einen Spinnprozess) überführt und in situ vernetzt.

Besonders bevorzugt ist das Bindemittel ein elastomeres Silicon, das insbesondere in einer mindestens zwei Komponenten enthaltenden Vorstufe (beispielsweise einer Silan-Komponente mit freien Si-H-Gruppen und einer Silylalkenyl-Komponente, z.B. einer Vinylsilyl-Komponente) eingesetzt und sodann vernetzt wurde, wobei die Partikel vorzugsweise vor der Vernetzung zugesetzt wurden.

Im Falle der Verwendung des erfindungsgemäßen Materials für Elektrodenschichten wird mit dem Einsatz des Bindemittels vermieden, dass die anisotropen leitfähigen Partikel nur eine geringe Haftung zur nichtleitenden Elastomerschicht haben. Im Falle der Verwendung für Fasern erhalten die Fasern durch die Verwendung eines Elastomers die gewünschten elastomeren Eigenschaften. Es ist bevorzugt, für Elektrodenschichten relativ weiche Bindemittel bzw. Elastomere zu verwenden. Für Fasern sollten die Elastomere eine höhere Festigkeit und/oder Steifigkeit aufweisen.

Das erfindungsgemäße Material lässt sich in einfacher Weise durch Vermischen der metallischen anisotropen Teilchen und der nichtmetallischen elektrisch leitenden Teilchen im entsprechenden Bindemittel bewerkstelligen. Handelt es sich bei dem Bindemittel um ein solches, das nachträglich vernetzt werden kann, ist es bevorzugt, die Teilchen mit dem unvernetzten Bindemittel zu mischen, das Material in die gewünschte Form zu bringen und erst sodann zu vernetzen. In vielen Fällen kann die Vernetzung thermisch, durch Bestrahlen mit Licht, z.B. durch UV-Bestrahlung, oder katalytisch bewirkt werden. Alle diese Vernetzungsarten können beispielsweise im Falle von Siliconen angewendet werden, die aus zwei oder mehr Ausgangsmaterialien gebildet werden. Anstelle einer Vernetzung kann das Bindemittel auch auf anderem Wege verfestigt werden, beispielsweise durch Abdampfen von Lösungsmittel oder - im Falle von Materialien wie thermoplastischen Elastomeren - durch Erstarren.

Nachfolgend soll die Erfindung in Hinblick auf die bevorzugte Verwendung in Elastomerkompositen näher beschrieben werden.

Hierbei wird erfindungsgemäß ein Dielektrischer Elastomerkomposit bereitgestellt, der/das eine dielektrische Schicht umfasst, welche beidseitig Elektrodenschichten aufweist, wobei die Elektrodenschichten aus dem erfindungsgemäßen Material gebildet sind.

Die Wahl des Materials für die nichtleitende Elastomerfolie für den Dielektrischen Elastomerkomposit ist nicht kritisch. Diesbezüglich kann auf die oben bereits als Bindemittel genannten Materialien verwiesen werden wie Silicon, Fluorsilicon, Polyurethan (PUR), Polynorbornen, Naturkautschuk (NR), Styrol-Butadien (SBR), Isobutylen-Isopren (IIR), Ethylen-Propylen-Dien-Terpolymer (EPDM/EPM), Poly-Chlorbutadien (CR), Chlorsulfoniertes Polyethylen (CSM), Acrylnitril-Butadien (NBR), Hydriertes Acrylnitril-Butadien (HNBR), ein thermoplastisches Elastomer wie thermoplastische Styrol-Copolymere (Styrol-Butadien-Styrol- (SBS-), Styrol-Ethylen-Butadien-Styrol- (SEBS-), Styrol-Ethylen-Propylen-Styrol- (SEPS-), Styrol-Ethylen-Ethylen-Propylen-Styrol- (SEEPS-) oder Styrol-Isopren-Styrol- (SIS-) Copolymer). Desweiteten können teilvernetzte Blends auf Polyolefin-Basis (aus Ethylen-Propylen-Dien-Kautschuk und Polypropylen (EPDM/PP), aus Nitril-Butadien-Kautschuk und Polypropylen (NBR/PP) oder aus Ethylen-Propylen-Dien-Kautschuk und Polyethylen (EPDM/PE)) oder thermoplastische Urethan-Copolymere (aromatisches Hartsegment und Ester-Weichsegment (TPU-ARES), aromatisches Hartsegment und Ether-Weichsegment (TPU-ARET) oder aromatisches Hartsegment und Ester/Ether-Weichsegment (TPU-AREE)) oder ein Fluorkautschuk wie Viton verwendet werden. Dabei kann die nichtleitende Elastomerfolie entweder aus einem oder aus mehreren der genannten Materialien bestehen oder eines oder mehrere davon enthalten.

In einer spezifischen Ausführungsform wird als Bindemittel der Elektrodenschichten ein weicheres Material eingesetzt als für die nichtleitende Elastomerfolie. Dabei kann es sich um Materialien handeln, die bezüglich der chemischen Komponenten identisch oder ähnlich sind, sich jedoch in ihrem Vernetzungsgrad unterscheiden. Beispielsweise können sowohl die nichtleitende Elastomerfolie wie auch das Bindemittel für die Elektrodenschichten aus einem vorzugsweise chemisch identischen, elastomeren Silicon bestehen, die sich nur oder im Wesentlichen nur hinsichtlich ihres Vernetzungsgrades unterscheiden.

Des Weiteren kann die nichtleitende Elastomerfolie elektrisch polarisierbare Partikel wie Bariumtitanat oder Titandioxid und/oder elektrisch leitfähige Partikel aus Kohlenstoff wie Graphit oder Carbon Nanotubes, Metalle wie Kupfer, Silber oder Gold oder leitfähige Polymere wie Polyanilin oder Polythiophen in einer Konzentration unterhalb der Perkolationsschwelle enthalten.

Die nichtleitende Elastomerfolie besitzt eine Dicke von in der Regel unter 1 mm, bevorzugt unter 500 µm und besonders bevorzugt unter 250 µm. Die leitfähigen Schichten besitzen in der Regel eine Dicke von unter 100 µm, bevorzugt unter 50 µm und besonders bevorzugt unter 25 µm.

In einer spezifischen Ausführungsform der Erfindung besitzt der Dielektrische Elastomerkomposit eine alternierende Abfolge von nichtleitenden Elastomerschichten und leitfähigen Schichten, wobei die leitfähigen Schichten abwechselnd als positive und als negative Elektrode geschaltet werden können und die positiven wie auch die negativen Elektroden jeweils miteinander und mit einer gemeinsamen elektrischen Zuleitung verbunden sind.

Die Elektrodenschichten können die gesamte nichtleitende Elastomerfolie bedecken; sie können jedoch auch nur Teile der Elastomerfolie bedecken und in dieser Ausgestaltung insbesondere auf einer oder jeder Seite mindestens zwei separat ansteuerbare Bereiche mit Elektrodenmaterial aufweisen.

Dabei oder unabhängig davon können die Elektrodenschichten die Form von ein- oder zweidimensionalen Elektroden-Arrays haben. Dabei können sich auf jeder Oberfläche der nichtleitenden Elastomerfolie ein, zwei oder mehr solcher Arrays (z.B. in Reihen und/oder Spalten angeordnet) befinden, die ggf. separat elektrisch angesteuert werden können.

In einer besonderen Ausführungsform der Erfindung, die mit jeder anderen voranstehend geschilderten Ausführungsform kombinierbar ist, sind die außenliegenden leitfähigen Schichten nach außen mit mindestens einer stark dehnbaren nichtleitenden Schutzschicht (Isolationsschicht) beschichtet.

Jede Elektrodenmaterial-Schicht wird für den Gebrauch mit einer elektrischen Zuleitung kontaktiert.

Zur Herstellung des erfindungsgemäßen Dielektrischen Elastomerkomposits kann beispielsweise ein elastomeres Silicon oder eine Vorstufe davon, die aus mindestens zwei Komponenten besteht, mit den metallischen anisotropen und den nichtmetallischen leitfähigen Partikeln vermischt werden. Die dabei erzeugte Mischung wird gegebenenfalls mit einem flüssigen Verdünnungsmittel, beispielsweise einem Alkohol oder einem Ester, verdünnt. Diese Mischung kann sodann flächig oder strukturiert auf die beiden Seiten einer Elastomerfolie aufgetragen werden. Die Verfestigung erfolgt durch Vernetzen oder Abdampfen von Lösungsmittel.

Eine spezifische Ausführungsform zum Herstellen eines Dielektrischen Elastomerkomposits umfasst die folgenden Schritte:
(a) Herstellen einer dehnbaren, nichtleitenden Elastomerfolie durch Aufbringen des für die Elastomerfolie eingesetzten Materials oder einer monomeren oder prepolymerisierten Vorstufe davon in flüssiger oder weicher Form auf eine Unterlage und Vernetzen oder Nachvernetzen des Materials oder der Vorstufe davon, vorzugsweise durch Anwendung von Wärme,
(b) Vermischen eines elastomeren Silicons oder einer Vorstufe davon, die aus mindestens zwei Komponenten besteht, mit leitfähigen Partikeln, die zumindest teilweise aus Metall bestehen und eine anisotrope Gestalt besitzen, sowie mit nichtmetallischen leitfähigen Partikeln, ausgewählt unter Partikeln aus Kohlenstoff-Materialien sowie Partikeln aus leitfähigen organischen Polymeren,
(c) gegebenenfalls Verdünnen der in Schritt (b) erhaltenen Mischung mit einem flüssigen Verdünnungsmittel,
(d) Aufbringen der in Schritt (b) bzw. in Schritt (c) erhaltenen Mischung als Schicht auf die Oberseite der Elastomerfolie,
(e) Ablösen der Elastomerfolie von der Unterlage,
(f) Aufbringen der in Schritt (b) bzw. in Schritt (c) erhaltenen Mischung als Schicht auf die Rückseite der Elastomerfolie und
(g) Verfestigen, Vernetzen oder Nachvernetzen der in Schritt (d) und in Schritt (f) auf den Oberflächen der Elastomerfolie aufgebrachten Mischung, vorzugsweise durch Anwendung von Wärme.

Das Verfestigen, Vernetzen oder Nachvernetzen der in Schritt (d) erhaltenen Schicht gemäß Schritt (g) erfolgt meist vor dem Ablösen der Elastomerfolie von der Unterlage (Schritt (e)) und dem Aufbringen der Rückseitenschicht gemäß (f); in manchen Fällen können die beiden Elektrodenschichten jedoch auch gemeinsam verfestigt, vernetzt bzw. nachvernetzt werden, sofern die aufgebrachten Schichten bereits als solche eine ausreichende Eigenstabilität zeigen, beispielsweise bei schnellem Abdampfen eines vorhandenen, niedersiedenden Lösungsmittels.

Der erfindungsgemäße Elastomerkomposit lässt sich beliebig verwenden, insbesondere als Dielektrischer Elastomeraktor, z. B. zur Verstellung von Klappen, Spiegeln und anderen optischen Elementen, für Ventile, Pumpen, Lautsprecher oder für haptische Bedienelemente, als Dielektrischer Elastomersensor, z. B. für Druckmessungen oder für großflächige Belastungsanalysen oder als Dielektrischer Elastomergenerator zur Wandlung von mechanischer in elektrische Energie.

Der erfindungsgemäße dielektrische Elastomerkomposit zeichnet sich dadurch aus, dass die darauf befindlichen Elektrodenschichten eine besonders hohe elektrische Leitfähigkeit aufweisen. Diese hohe Leitfähigkeit wird auch unter starker Dehnung des Elastomerkomposits fast unverändert aufrechterhalten. Wie die nachstehenden Vergleichsbeispiele und Beispiele zeigen, lässt sich mit den erfindungsgemäßen Maßnahmen ein Dielektrischer Elastomerkomposit mit einem Elektrodenmaterial erhalten, das eine spezifische Leitfähigkeit von mindestens 150 S/cm im ungedehnten Zustand zeigt, die selbst bei einer Dehnung um 160% immer noch bei etwa 8 S/cm liegt. Außerdem ist der mechanische Widerstand der Elektrodenschichten bei einer Dehnung des Elastomerkomposits relativ gering

Diese Eigenschaften machen das erfindungsgemäße Material interessant auch für andere Zwecke. So ist, wie oben erwähnt, dessen Verwendung für leitfähige Elastomerfasern ebenfalls günstig. Diese Fasern sollen sich stark dehnen lassen, ohne ihre Leitfähigkeit zu verlieren. Fasern aus dem erfindungsgemäßen Material zeigen diese Eigenschaften.

Zur Herstellung von Fasern können gängige Verfahren eingesetzt werden, beispielsweise Spinnverfahren. Hierfür kann das oben beschriebene Material als Spinnmasse genutzt werden. Diese wird durch Düsen gedrückt, und die sich bildenden Fasern/Fäden werden abgezogen, durch eine Verfestigungszone geführt und im verfestigten Zustand z.B. auf eine Trommel aufgewickelt. Die Verfestigung erfolgt durch Vernetzung. Diese kann beispielsweise mit Hilfe von Strahlung, beispielsweise IR- oder UV-Licht, oder durch das Führen der Fasern/Fäden durch eine Wärmezone erfolgen. Die Verfestigungszone befindet sich vorzugsweise nahe am Austrittsort der Fasern/Fäden aus der Düse, z.B. direkt unterhalb davon.

Die Erfindung soll nachstehend anhand von Ausführungsbeispielen und Vergleichsbeispielen näher erläutert werden.

### A. Materialbeispiele

### Materialbeispiel 1 (Vergleichsbeispiel)

Herstellung eines Materials aus leitfähigen Partikeln, die zumindest teilweise aus Metall bestehen und eine anisotrope Gestalt besitzen, und einem Bindemittel

Zur Herstellung des Materials wurden 34 Vol.-% versilberte Glasflakes (Größe ca. 10 µm, Dicke ca. 1 µm, Silbergehalt 40%) in eine Mischung der Siliconvorstufen Elastosil RT 625 eingebracht, die zuvor im Verhältnis 9:1 mit 40 Vol.-% eines Siliconöls vermischt worden war, und mit einem Speedmixer verteilt.

### Materialbeispiel 2 (Vergleichsbeispiel)

Beispiel 1 wurde wiederholt mit der Maßgabe, dass anstelle von 34 Vol.-% versilberten Glasflakes 25 Vol.-% versilberte Glasflakes eingesetzt wurden.

### Materialbeispiel 3 (Vergleichsbeispiel)

Die Vorstufen für ein weitmaschig vernetztes Polydimethylsiloxan wurden vorgelegt und mit 15 Vol.-% versilberter Flakes mit metallischem Kern zusammengegeben. Die Partikel wurden mit einem Speedmixer verteilt. Unmittelbar vor der Überführung des Materials in die gewünschte Endform wurde ein üblicher Platin-Katalysator zugesetzt, um die Vernetzung in Gang zu setzen.

### Materialbeispiel 4 (Vergleichsbeispiel)

Beispiel 3 wurde wiederholt mit der Maßgabe, dass anstelle von versilberten Flakes mit metallischem Kern Leitruß in einer Konzentration von 6 Vol.-% eingesetzt wurde.

### Materialbeispiel 5

In eine Mischung der Siliconvorstufen gemäß Materialbeispiel 3 wurden 15 Vol.-% versilberte Flakes mit metallischem Kern und 6 Vol.-% Leitruß gegeben und mit einem Speedmixer verteilt. Die Vernetzung erfolgte wie für Materialbeispiel 3 angegeben.

### Materialbeispiel 6

Materialbeispiel 5 wurde mit der Änderung wiederholt, dass anstelle von 6 Vol.-% Leitruß nur 3 Vol.-% Leitruß eingemischt wurden.

### Materialbeispiel 7

Materialbeispiel 5 wurde mit der Änderung wiederholt, dass anstelle von 15 Vol.-% 20 Vol.-% versilberte Flakes mit metallischem Kern verwendet wurden.

### Materialbeispiel 8

Materialbeispiel 6 wurde mit der Änderung wiederholt, dass anstelle von 15 Vol.-% 20 Vol.-% versilberte Flakes mit metallischem Kern verwendet wurden.

### B. Beispiele für einen Dielektrischen Elastomerkomposit

Die spezifische Leitfähigkeit der Elektrodenschichten dieser Dielektrischen Elastomerkomposite wurde durch Anlegen einer Spannung zwischen den Enden der Elektrodenschicht, Messung der Stromstärke und Bestimmung des elektrischen Widerstandes sowie mit den geometrischen Dimensionen der Elektrodenschicht bestimmt. Dabei wurde die Elektrodenschicht zusammen mit der darunterliegenden Siliconfolie stufenweise gedehnt, bis der Widerstand deutlich anstieg oder nicht mehr messbar war oder die Dehnung 200% erreichte.

### Vergleichsbeispiel 1

Zur Herstellung eines dielektrischen Elastomerkomposits wurde zunächst aus Siliconvorstufen Elastosil RT 625 eine Siliconfolie als Dielektrikum hergestellt. Hierzu wurden die zwei Siliconkomponenten im Verhältnis 9:1 mit 40% eines Siliconöls gemischt. Durch einen Rakelprozess und anschließende thermische Vernetzung mit einem Infrarotstrahler wurde eine Siliconfolie mit einer Dicke von 260 µm erzeugt.

Zur Herstellung der Elektrodenmasse wurden 34 Vol.-% versilberte Glasflakes (Größe ca. 10 µm, Dicke ca. 1 µm, Silbergehalt 40%) in den flüssigen Siliconvorstufen mit einem Speedmixer verteilt. Um eine sprühbare Konsistenz zu erzeugen, wurden zu 10 g Elektrodenmischung 20 g Butylacetat hinzugegeben. Die verdünnte Elektrodenmischung wurde unter Verwendung einer Schattenmaske auf beiden Seiten auf die Siliconfolie aufgetragen. Auch das Silicon der Elektrodenmasse wurde mit einem Infrarotstrahler thermisch vernetzt.

### Vergleichsbeispiel 2

Vergleichsbeispiel 1 wurde wiederholt mit der Maßgabe, dass für die Elektrodenfolien anstelle von 34 Vol.-% versilberten Glasflakes 25 Vol.-% versilberte Glasflakes eingesetzt wurden. Butylacetat wurde in einer solchen Menge hinzugegeben, dass eine sprühbare Konsistenz erzielt wurde.

### Vergleichsbeispiel 3

Vergleichsbeispiel 1 wurde mit der Maßgabe wiederholt, dass zur Herstellung der Elektrodenmasse 15 Vol.-% versilberte Flakes mit metallischem Kern eingesetzt wurden. Butylacetat wurde in einer solchen Menge hinzugegeben, dass eine applizierbare Konsistenz erzielt wurde. Die Konsistenz wurde je nach gewünschtem Auftragsverfahren gewählt, d.h. z.B. dünnflüssiger für ein Sprühverfahren und dickflüssiger für ein Rakelverfahren. Die Dicke gerakelter Elektrodenschichten betrug 14 µm. Ihre Leitfähigkeit lag im ungedehnten Zustand bei ca. 60 S/cm.

### Vergleichsbeispiel 4

Vergleichsbeispiel 3 wurde wiederholt mit der Maßgabe, dass anstelle von versilberten Flakes mit metallischem Kern Leitruß in einer Konzentration von 6 Vol.-% eingesetzt wurde. Butylacetat wurde in einer solchen Menge hinzugegeben, dass eine applizierbare Konsistenz (dünnflüssiger für Sprühverfahren, dickflüssiger für Rakelverfahren) erzielt wurde. Die Schichtdicke der gerakelten Elektroden betrug 14 µm.

### Beispiel 5

In eine Mischung der Siliconvorstufen wurden 15 Vol.-% versilberte Flakes mit metallischem Kern und 6 Vol.-% Leitruß gegeben und mit einem Speedmixer verteilt. Butylacetat wurde in einer solchen Menge hinzugegeben, dass eine applizierbare Konsistenz erzielt wurde. Mit diesem Material wurden Elektroden auf eine Silikonfolie gerakelt und ausgehärtet wie in Vergleichsbeispiel 3 dargestellt. Die Schichtdicke der Elektrode betrug 6 µm. Im ungedehnten Zustand betrug die spezifische Leitfähigkeit der Elektroden annähernd 150 S/cm.

### Beispiel 6

Beispiel 5 wurde mit der Änderung wiederholt, dass anstelle von 6 Vol.-% Leitruß nur 3 Vol.-% Leitruß eingemischt wurden. Butylacetat wurde in einer solchen Menge hinzugegeben, dass eine rakelfähige Konsistenz erzielt wurde. Die aufgerakelten Elektroden besaßen nach dem Aushärten eine Dicke von 5 µm.

### Beispiel 7

Beispiel 5 wurde mit der Änderung wiederholt, dass anstelle von 15 Vol.-% 20 Vol.-% versilberte Flakes mit metallischem Kern verwendet wurden. Butylacetat wurde in einer solchen Menge hinzugegeben, dass eine rakelfähige Konsistenz erzielt wurde. Die aufgerakelten Elektroden besaßen nach dem Aushärten eine Dicke von 5 µm.

### Beispiel 8

Beispiel 6 wurde mit der Änderung wiederholt, dass anstelle von 15 Vol.-% 20 Vol.-% versilberte Flakes mit metallischem Kern verwendet wurden. Die aufgerakelten Elektroden besaßen nach dem Aushärten eine Dicke von 6 µm.

Die ungefähre spezifische Leitfähigkeit [S/cm] der Beispiele und Vergleichsbeispiele bei verschiedenen Dehnungen der Elektrodenschichten (aufgesprüht für Vergleichsbeispiel 1, aufgerakelt für die Vergleichsbeispiele 3 und 4 sowie die Beispiele) wurde wie voranstehend erläutert gemessen und ergab sich dabei wie folgt (ungedehnter Zustand = 0% Dehnung):

| (Vergleichs-)Beispiele | 0% Dehnung | 100% Dehnung | 140% Dehnung | 160% Dehnung | 180% Dehnung |
|---|---|---|---|---|---|
| 1 | 60 | 15 | 3 | 0,0003 | n.m. |
| 2 | n.g. | n.g. | n.g. | n.g. | n.g. |
| 3 | 60 | 2 | 0,1 | 0,002 | n.m. |
| 4 | 0,1 | 0,1 | 0,08 | 0,07 | 0,06 |
| 5 | 150 | 15 | 10 | 8 | 7 |
| 6 | 100 | 20 | 15 | 10 | 9 |
| 7 | 130 | 25 | 18 | 15 | 11 |
| 8 | 200 | 12 | 8 | 6 | 5 |

| | | | | | |
|---|---|---|---|---|---|
| n.m. bedeutet nicht messbar, n.g. bedeutet nicht gemessen | | | | | |

Aus der Tabelle lässt sich folgendes ableiten:
(a) Die Verwendung von anisotropen metallischen Flakes allein führt zu einer hohen spezifischen Leitfähigkeit der Materialien im ungedehnten Zustand. Wird stattdessen ein nichtmetallisches leitendes Material verwendet, insbesondere ein Kohlenstoff-Material wie Ruß, so ist die erzielte Leitfähigkeit um mehrere Zehnerpotenzen kleiner. Wird eine Kombination aus beiden Arten von leitfähigen Partikeln, anisotropen metallischen Flakes und Kohlenstoff-Partikel wie Ruß, verwendet, so ist die Leitfähigkeit vergleichbar oder etwas höher als die Leitfähigkeit von Materialien, die nur mit metallischen anisotropen Teilchen befüllt sind.
(b) Die Abnahme der Leitfähigkeit unter Dehnung ist in mit anisotropen Flakes allein befüllten Materialien sehr stark. Bei einer Dehnung um 100%, also auf die doppelte Länge, nimmt sie zwar durchschnittlich nur um etwa eine Zehnerpotenz ab; bei stärkerer Dehnung geht die Leitfähigkeit jedoch nach und nach völlig verloren, so dass sie bei einer Dehnung um 140 oder gar 160% völlig marginal wird. In diesen Dehnungsbereichen leitet selbst Ruß ohne den Zusatz von anisotropen Flakes besser. Wird jedoch eine Mischung aus beiden verwendet, nimmt die Leitfähigkeit bei zunehmender Dehnung wesentlich weniger stark ab, wobei sie bei Dehnungen im Bereich von 140 bis 160% um ca. 2 Zehnerpotenzen über Elektrodenmischungen liegt, in denen ausschließlich anisotrope Flakes verwendet werden, und bei weiterer Dehnung kaum weiter abnimmt.

Die beiden unter (a) und (b) aufgezeigten Effekte sind synergetischer Natur und konnten nicht erwartet werden.

### C. Beispiele für leitfähige Elastomerfasern

Vergleichsbeispiel 1 wurde mit der Maßgabe eingesetzt, dass das Siliconöl weggelassen wurde. Materialbeispiel 5 wurde mit Siloxan-Vorstufen wiederholt, aus denen ein Polymdimethylsiloxan mit einer engermaschigen Vernetzung entsteht als im Materialbeispiel 5. Nach Vernetzung besitzen beide Massen eine höhere Steifigkeit als die Massen des Vergleichsbeispiels 1 und des Materialbeispiels 5.

Die beiden Massen wurden jeweils durch eine Spinndüse gedrückt, und die dabei entstehenden Fäden wurden direkt unterhalb der Spinndüse durch eine mit Strahlung im Infrarotbereich bestrahlte Zone geführt. Die verfestigten Fäden wurden auf eine Trommel aufgewickelt. Bei Dehnungsversuchen zeigte sich, dass die spezifische Leitfähigkeit von Fasern aus dem Material des Beispiels 5 deutlich geringer abfiel als die von Fasern aus dem Vergleichsbeispiel 1.

## Patentansprüche

1. Elektrisch leitendes Material, umfassend
(a) leitfähige Partikel, die zumindest teilweise aus Metall bestehen und eine anisotrope Gestalt besitzen,
(b) nichtmetallische leitfähige Partikel, ausgewählt unter Partikeln aus Kohlenstoff-Materialien sowie Partikeln aus leitfähigen organischen Polymeren und
(c) ein elastomeres Bindemittel, ausgewählt unter Silicon, Fluorsilicon, Polyurethan (PUR), Polynorbornen, Naturkautschuk (NR), Styrol-Butadien (SBR), Isobutylen-Isopren (IIR), Ethylen-Propylen-Dien-Terpolymer (EPDM/EPM), Poly-Chlorbutadien (CR), Chlorsulfoniertem Polyethylen (CSM), Acrylnitril-Butadien (NBR), Hydriertem Acrylnitril-Butadien (HNBR), einem thermoplastischen Elastomer, einem teilvernetzten Blend auf Polyolefin-Basis, oder einem thermoplastischen Urethan-Copolymer, ausgewählt aus Copolymeren mit aromatischem Hartsegment und Ester-Weichsegment (TPU-ARES), aromatischem Hartsegment und Ether-Weichsegment (TPU-ARET) und aromatischem Hartsegment und Ester/Ether-Weichsegment (TPU-AREE) und Mischungen der vorgenannten Elastomer-Materialien,
wobei der Anteil der metallischen anisotropen Partikel mindestens 50 Gew.-% und/oder mindestens 10 Vol.-% beträgt.

2. Elektrisch leitendes Material nach Anspruch 1, wobei die Partikel mit anisotroper Gestalt Plättchen-, Stäbchen- oder Faserform besitzen und/oder eine stark unregelmäßige Oberfläche besitzen, die insbesondere dadurch hervorgerufen ist, dass die Partikel durch Agglomeration von Nanopartikeln entstanden sind.

3. Elektrisch leitendes Material nach einem der voranstehenden Ansprüche, worin die Partikel mit anisotroper Gestalt mindestens ein Metall, ausgewählt unter Aluminium, Eisen, Kupfer, Silber, Gold und/oder Platin, enthalten oder daraus bestehen.

4. Elektrisch leitendes Material nach einem der voranstehenden Ansprüche, worin die Partikel mit anisotroper Gestalt Kompositpartikel aus einem Kern mit einer leitfähigen Beschichtung sind, wobei bevorzugt der Kern aus Glas oder einem anderen Metall und/oder die Beschichtung aus Silber besteht.

5. Elektrisch leitendes Material nach einem der voranstehenden Ansprüche, worin die nichtmetallischen leitfähigen Partikel aus einem Material bestehen, das ausgewählt ist unter Ruß, Graphit, Graphen, Kohlenstoff-Nanoröhren, Polyanilin, Polyacetylen, Polypyrrol, Polyparaphenylen oder Polythiophen sowie Mischungen davon.

6. Elektrisch leitendes Material nach einem der voranstehenden Ansprüche, worin der Anteil der metallischen anisotropen Partikel mindestens 75 Gew.-% und/oder mindestens 20 Vol.-% beträgt.

7. Elektrisch leitendes Material nach einem der voranstehenden Ansprüche, worin das Bindemittel ein thermoplastisches Styrol-Copolymer, ausgewählt unter Styrol-Butadien-Styrol- (SBS-), Styrol-Ethylen-Butadien-Styrol- (SEBS-), Styrol-Ethylen-Propylen-Styrol-(SEPS-), Styrol-Ethylen-Ethylen-Propylen-Styrol- (SEEPS-) oder Styrol-Isopren-Styrol-(SIS-) Copolymeren, oder ein teilvernetztes Blend auf Polyolefin-Basis ist, ausgewählt unter Blends aus Ethylen-Propylen-Dien-Kautschuken und Polypropylen (EPDM/PP), aus Nitril-Butadien-Kautschuk und Polypropylen (NBR/PP) und aus Ethylen-Propylen-Dien-Kautschuk und Polyethylen (EPDM/PE).

8. Elektrisch leitendes Material nach Anspruch 7, worin das Elastomer ein elastomeres Silicon ist, das in einer mindestens zwei Komponenten enthaltenden Vorstufe eingesetzt und sodann vernetzt wurde, wobei die Partikel bevorzugt vor der Vernetzung zugesetzt wurden.

9. Verwendung eines elektrisch leitenden Materials nach einem der voranstehenden Ansprüche als Beschichtung, die sich beidseitig einer dehnbaren nichtleitenden Elastomerfolie befindet und als Elektrodenschicht dient, derart, dass der Schichtverbund aus nichtleitender Elastomerfolie und den beidseitigen Beschichtungen einen Dielektrischen Elastomerkomposit darstellt, der als Dielektrischer Elastomeraktor, Dielektrischer Elastomersensor oder Dielektrischer Elastomergenerator dienen kann.

10. Verwendung nach Anspruch 9, wobei die nichtleitende Elastomerfolie Silicon, Fluorsilicon, Polyurethan (PUR), Polynorbornen, Naturkautschuk (NR), Styrol-Butadien (SBR), Isobutylen-Isopren (IIR), Ethylen-Propylen-Dien-Terpolymer (EPDM/EPM), Poly-Chlorbutadien (CR), Chlorsulfoniertes Polyethylen (CSM), Acrylnitril-Butadien (NBR), Hydriertes Acrylnitril-Butadien (HNBR), einen Fluorkautschuk, ein thermoplastisches Elastomer, vorzugsweise ein thermoplastisches Styrol-Copolymer, ausgewählt unter Styrol-Butadien-Styrol- (SBS-), Styrol-Ethylen-Butadien-Styrol- (SEBS-), Styrol-Ethylen-Propylen-Styrol- (SEPS-), Styrol-Ethylen-Ethylen-Propylen-Styrol- (SEEPS-) oder Styrol-Isopren-Styrol- (SIS-) Copolymeren, ein teilvernetztes Blend auf Polyolefin-Basis, vorzugsweise ausgewählt unter Blends aus Ethylen-Propylen-Dien-Kautschuken und Polypropylen (EPDM/PP), aus Nitril-Butadien-Kautschuk und Polypropylen (NBR/PP) und aus Ethylen-Propylen-Dien-Kautschuk und Polyethylen (EPDM/PE), oder ein thermoplastisches Urethan-Copolymer, ausgewählt aus Copolymeren mit aromatischem Hartsegment und Ester-Weichsegment (TPU-ARES), aromatischem Hartsegment und Ether-Weichsegment (TPU-ARET) und aromatischem Hartsegment und Ester/Ether-Weichsegment (TPU-AREE), enthält oder daraus besteht.

11. Verwendung nach Anspruch 9 oder 10, worin als Bindemittel der Elektrodenschichten ein weicheres Material eingesetzt wird als das Material, das für die nichtleitende Elastomerfolie verwendet wird, wobei das Bindemittel der Elektrodenschichten und das Material für die nichtleitende Elastomerfolie vorzugsweise aus denselben oder ähnlichen chemischen Komponenten aufgebaut sind, sich jedoch in ihrem Vernetzungsgrad unterscheiden.

12. Verwendung nach einem der Ansprüche 9 bis 11, wobei die nichtleitende Elastomerfolie eine Dicke von unter 1 mm, bevorzugt unter 500 µm, besonders bevorzugt unter 250 µm aufweist und/oder die leitfähigen Schichten eine Dicke von unter 100 µm, bevorzugt unter 50 µm, besonders bevorzugt unter 25 µm aufweisen.

13. Verwendung nach einem der Ansprüche 9 bis 12, worin der Dielektrische Elastomerkomposit als Multischichtsystem ausgebildet ist, **dadurch gekennzeichnet, dass** mindestens auf einer der Beschichtungen aus dem Elektrodenmaterial eine oder mehrere Doppelschicht(en) aufgebracht ist/sind, umfassend eine weitere Schicht einer nichtleitenden dehnbaren Elastomerfolie und eine weitere Schicht aus einem Material wie in Anspruch 1 definiert als Elektrodenmaterial, derart, dass jeweils zwei Beschichtungen aus dem Elektrodenmaterial durch eine nichtleitende dehnbare Elastomerfolie voneinander getrennt sind und umgekehrt, wobei die Schichten aus Elektrodenmaterial alternierend als positive und als negative Elektrode geschaltet werden können oder geschaltet sind.

14. Verwendung eines elektrisch leitenden Materials nach einem der Ansprüche 1 bis 8 als Material einer elektrisch leitenden Elastomerfaser.

## Claims

1. Electrically conductive material comprising
(a) conductive particles at least partially consisting of metal and having an anisotropic structure,
(b) non-metallic conductive particles selected from particles of carbon materials and particles of conductive organic polymers, and
(c) an elastomeric binder selected from silicone, fluorosilicone, polyurethane (PUR), polynorbornene rubber, natural rubber (NR), styrene-butadiene (SBR), isobutylene-isoprene (IIR), ethylene-propylene diene terpolymer (EPDM/EPM), poly-chlorobutadiene (CR), chlorosulfonated polyethylene (CSM), acrylonitrile-butadiene (NBR), hydrogenated acrylonitrile-butadiene (HNBR), a thermoplastic elastomer, a partially crosslinked blend on basis of polyolefin, or a thermoplastic urethane copolymer selected from copolymers having aromatic hard segment and ester soft segment (TPU ARES), aromatic hard segment and ether ester soft segment (TPU-ARET) and aromatic hard segment and ester/ether soft segment (TPU AREE) and mixtures of the abovementioned elastomeric materials,
wherein the content of the metallic anisotropic particles is at least 50 % by weight and/or at least 10 % by volume.

2. Electrically conductive material according to claim 1, wherein the particles having anisotropic structure have the shape of flakes, rods or fibers and/or have a highly irregular surface, which is particularly caused by the fact that the particles are formed by agglomeration of nanoparticles.

3. Electrically conductive material according to any one of the preceding claims, wherein the particles having an anisotropic structure contain or consist of at least one metal selected from aluminum, iron, copper, silver, gold and/or platinum.

4. Electrically conductive material according to any one of the preceding claims, wherein the particles having anisotropic structure are composite particles of a core with a conductive coating, wherein the core preferably consists of glass or another metal and/or the coating consists of silver.

5. Electrically conductive material according to any one of the preceding claims, wherein the non-metallic conductive particles consist of a material which is selected from carbon black, graphite, graphene, carbon nanotubes, polyaniline, polyacetylene, polypyrrole, polyparaphenylene or polythiophene and mixtures thereof.

6. Electrically conductive material according to any one of the preceding claims, wherein the proportion of metallic anisotropic particles is at least 50 % by weight and/or at least 20 % by volume.

7. Electrically conductive material according to any one of the preceding claims, wherein the binder is a thermoplastic styrene copolymer, selected from styrene-butadiene-styrene (SBS), styrene-ethylene-butadiene-styrene (SEBS), styrene-ethylene-propylene-styrene (SEPS), styrene-ethylene-ethylene-propylene-styrene (SEEPS) or styrene-isoprene-styrene (SIS) copolymer, or a partially crosslinked blend on the basis of polyolefin, selected from blends of ethylene-propylene-diene rubber and polypropylene (EPDM/PP), nitrile-butadiene rubber and polypropylene (NBR/PP) and ethylene-propylene-diene rubber and polyethylene (EPDM/PE).

8. Electrically conductive material according to any one of the preceding claims, wherein the elastomer is an elastomeric silicone that was used in a precursor containing at least two components and subsequently cured, wherein the particles were preferably added before the crosslinking.

9. Use of an electrically conductive material according to any one of the preceding claims as a coating, which is located on both sides of a stretchable non-conductive elastomer film and serves as an electrode layer, such that the layer composite of non-conductive elastomer film and the two-sided coating is a dielectric elastomer composite that can serve as a dielectric elastomer actuator, a dielectric elastomer sensor or dielectric elastomer generator.

10. The use according to claim 9, wherein the non-conductive elastomer film contains or consists of silicone, fluorosilicone, polyurethane (PUR), polynorbornene rubber, natural rubber (NR), styrene-butadiene (SBR), isobutylene-isoprene (IIR), ethylene-propylene-diene terpolymer (EPDM/EPM), poly-chlorobutadiene (CR), chlorosulfonated polyethylene (CSM), acrylonitrile-butadiene (NBR), hydrogenated acrylonitrile butadiene (HNBR), a fluorine rubber, a thermoplastic elastomer, preferably a thermoplastic styrene copolymer selected from styrene-butadiene styrene (SBS), styrene-ethylene-butadiene-styrene (SEBS), styrene-ethylene-propylene-styrene (SEPS), styrene-ethylene-ethylene-propylene-styrene (SEEPS) or styrene- isoprene-styrene (SIS) copolymer, a partially crosslinked blend on the basis of polyolefin, preferably selected from blends of ethylene-propylene-diene rubber and polypropylene (EPDM/PP), nitrile-butadiene rubber and polypropylene (NBR/PP) and of ethylene-propylene-diene rubber and polyethylene (EPDM/PE), or a thermoplastic urethane copolymer selected from copolymers having aromatic hard segment and ester soft segment (TPU ARES), aromatic hard segment and ether ester soft segment (TPU ARET) and aromatic hard segment and ester/ether ester soft segment (TPU AREE).

11. The use of claim 9 or 10, wherein, as binder of the electrode layers, a material is used that is softer than the material that is used for the non-conductive elastomer film, wherein the binder of the electrode layers and the material for the non-conductive elastomer film are preferably made of the same or similar chemical components, but differ in their degree of crosslinking.

12. The use according to any one of claims 9 to 11, wherein the non-conductive elastomer film has a thickness of less than 1 mm, preferably below 500 µm, more preferably below 250 µm and/or the conductive layers have a thickness of below 100 µm, preferably below 50 µm, more preferably below 25 µm.

13. The use according to any one of claims 9 to 12, wherein the dielectric elastomer composite is formed as a multi-layer system, **characterized in that** at least on one of the coatings made of the electrode material one or more bilayer(s) is/are applied, comprising a further layer of non-conductive extensible elastomeric film and a further layer of a material as defined in claim 1 as an electrode material, such that in each case two coatings made of the electrode material are separated from each other by a non-conductive extensible elastomeric film and vice versa, wherein the layers made of electrode material are or can be connected alternately as a positive and as a negative electrode.

14. The use of an electrically conductive material according to any one of claims 1 to 8 as a material of an electrically conductive elastomeric fiber.

## Revendications

1. Matériau conducteur de l'électricité, comprenant
(a) des particules conductrices, qui se composent au moins partiellement de métal et qui possèdent une forme anisotrope,
(b) des particules conductrices non métalliques, choisies parmi des particules de matériaux carbonés ainsi que des particules en polymères organiques conducteurs, et
(c) un liant élastomère, choisi parmi silicone, fluorosilicone, polyuréthane (PUR), polynorbornène, caoutchouc naturel (NR), styrène-butadiène (SBR), isobutylène-isoprène (IIR), terpolymère éthylène-propylène-diène (EPDM/EPM), poly-chlorobutadiène (CR), polyéthylène chlorosulfoné (CSM), acrylonitrile-butadiène (NBR), acrylonitrile-butadiène hydrogéné (HNBR), un élastomère thermoplastique, un mélange partiellement réticulé à base de polyoléfine, ou un copolymère d'uréthane thermoplastique, choisi parmi des copolymères avec segment dur aromatique et segment mou d'ester (TPU-ARES), segment dur aromatique et segment mou d'éther (TPU-ARET) et segment dur aromatique et segment mou d'ester/éther (TPU-AREE) et des mélanges des matériaux élastomères précités,
dans lequel la part des particules anisotropes métalliques vaut au moins 50 % en poids et/ou au moins 10 % en volume.

2. Matériau conducteur de l'électricité selon la revendication 1, dans lequel les particules avec une forme anisotrope ont une forme de plaquette, de bâtonnet ou de fibre et/ou présentent une surface fortement irrégulière, qui est due en particulier au fait que les particules sont obtenues par agglomération de nanoparticules.

3. Matériau conducteur de l'électricité selon l'une quelconque des revendications précédentes, dans lequel les particules avec une forme anisotrope contiennent au moins un métal, choisi parmi l'aluminium, le fer, le cuivre, l'argent, l'or et/ou le platine, ou en sont constituées.

4. Matériau conducteur de l'électricité selon l'une quelconque des revendications précédentes, dans lequel les particules avec une forme anisotrope sont des particules composites composées d'un noyau avec un revêtement conducteur, dans lequel le noyau se compose de préférence de verre ou d'un autre métal et/ou le revêtement d'argent.

5. Matériau conducteur de l'électricité selon l'une quelconque des revendications précédentes, dans lequel les particules conductrices non métalliques se composent d'un matériau, qui est choisi parmi la suie, le graphite, le graphène, des nanotubes de carbone, la polyaniline, le polyacétylène, le polypyrrole, le polyparaphénylène ou le polythiophène, ainsi que des mélanges de ceux-ci.

6. Matériau conducteur de l'électricité selon l'une quelconque des revendications précédentes, dans lequel la part des particules anisotropes métalliques vaut au moins 75 % en poids et/ou au moins 20 % en volume.

7. Matériau conducteur de l'électricité selon l'une quelconque des revendications précédentes, dans lequel le liant est un copolymère de styrène thermoplastique, choisi parmi les copolymères styrène-butadiène-styrène (SBS-), styrène-éthylène-butadiène-styrène (SEBS-), styrène-éthylène-propylène-styrène (SEPS-), styrène-éthylène-éthylène-propylène-styrène (SEEPS-) ou styrène-isoprène-styrène (SIS-), ou un mélange partiellement réticulé à base de polyoléfine, choisi parmi des mélanges de caoutchoucs éthylène-propylène-diène et polypropylène (EPDM/PP), de caoutchouc nitrile-butadiène et polypropylène (NBR/PP) et de caoutchouc éthylène-propylène-diène et polyéthylène (EPDM/PE).

8. Matériau conducteur de l'électricité selon la revendication 7, dans lequel l'élastomère est un silicone élastomère, qui a été utilisée dans un précurseur contenant au moins deux composants et a ensuite été réticulée, dans lequel les particules ont de préférence été ajoutées avant la réticulation.

9. Utilisation d'un matériau conducteur de l'électricité selon l'une quelconque des revendications précédentes comme revêtement, qui se trouve sur les deux faces d'un film d'élastomère extensible non conducteur et qui sert de couche d'électrode, de telle manière que le composite stratifié composé du film d'élastomère non conducteur et des revêtements sur les deux faces représente un composite d'élastomère diélectrique, qui peut servir comme acteur élastomère diélectrique, comme capteur élastomère diélectrique ou comme générateur élastomère diélectrique.

10. Utilisation selon la revendication 9, dans laquelle le film d'élastomère non conducteur contient du silicone, fluorosilicone, polyuréthane (PUR), polynorbornène, caoutchouc naturel (NR), styrène-butadiène (SBR), isobutylène-isoprène (IIR), terpolymère éthylène-propylène-diène (EPDM/EPM), poly-chlorobutadiène (CR), polyéthylène chlorosulfoné (CSM), acrylonitrile-butadiène (NBR), acrylonitrile-butadiène hydrogéné (HNBR), un caoutchouc fluoré, un élastomère thermoplastique, de préférence un copolymère de styrène thermoplastique, choisi parmi les copolymères styrène-butadiène-styrène (SBS-), styrène-éthylène-butadiène-styrène (SEBS-), styrène-éthylène-propylène-styrène (SEPS-), styrène-éthylène-éthylène-propylène-styrène (SEEPS-) ou styrène-isoprène-styrène (SIS-), un mélange partiellement réticulé à base de polyoléfine, choisi parmi des mélanges de caoutchoucs éthylène-propylène-diène et polypropylène (EPDM/PP), de caoutchouc nitrile-butadiène et polypropylène (NBR/PP) et de caoutchouc éthylène-propylène-diène et polyéthylène (EPDM/PE), ou un copolymère d'uréthane thermoplastique, choisi parmi des copolymères avec segment dur aromatique et segment mou d'ester (TPU-ARES), segment dur aromatique et segment mou d'éther (TPU-ARET) et segment dur aromatique et segment mou d'ester/éther (TPU-AREE), ou en est constitué.

11. Utilisation selon la revendication 9 ou 10, dans laquelle on utilise comme liant des couches d'électrode un matériau plus mou que le matériau qui est utilisé pour le film d'élastomère non conducteur, dans laquelle le liant des couches d'électrode et le matériau pour le film d'élastomère non conducteur sont de préférence constitués à partir de composants chimiques identiques ou analogues, mais diffèrent cependant par leur degré de réticulation.

12. Utilisation selon l'une quelconque des revendications 9 à 11, dans laquelle le film d'élastomère non conducteur présente une épaisseur de moins de 1 mm, de préférence de moins de 500 µm, de préférence encore de moins de 250 µm et/ou les couches conductrices présentent une épaisseur de moins de 100 µm, de préférence de moins de 50 µm, et de préférence encore de moins de 25 µm.

13. Utilisation selon l'une quelconque des revendications 9 à 12, dans laquelle le composite d'élastomère diélectrique est configuré en un système multicouche, **caractérisé en ce qu'**une ou plusieurs double(s) couche(s) est/sont déposées au moins sur un des revêtements en matériau d'électrode, lesquelles comprennent une autre couche d'un film d'élastomère extensible non conducteur et une autre couche d'un matériau tel que défini dans la revendication 1 comme matériau d'électrode, de telle manière que chaque fois deux revêtements en matériau d'électrode soient séparés l'un de l'autre par un film d'élastomère extensible non conducteur et inversement, dans laquelle les couches en matériau d'électrode peuvent être ou sont connectées en alternance comme électrode positive et comme électrode négative.

14. Utilisation d'un matériau conducteur de l'électricité selon l'une quelconque des revendications 1 à 8 comme matériau d'une fibre d'élastomère conductrice de l'électricité.
